(19) Europäisches Patentamt
European Patent Office
Office européen des brevets

(11) EP 4 293 892 A1

(12) **EUROPEAN PATENT APPLICATION**
published in accordance with Art. 153(4) EPC

(43) Date of publication:
**20.12.2023 Bulletin 2023/51**

(21) Application number: **22752681.1**

(22) Date of filing: **03.02.2022**

(51) International Patent Classification (IPC):
*H02N 2/04* (2006.01)        *B32B 25/08* (2006.01)
*B32B 27/18* (2006.01)        *H01L 41/083* (2006.01)
*H01L 41/09* (2006.01)        *H01L 41/193* (2006.01)

(52) Cooperative Patent Classification (CPC):
**B32B 25/08; B32B 27/18; H02N 2/04; H10N 30/20;
H10N 30/50; H10N 30/857**

(86) International application number:
**PCT/JP2022/004274**

(87) International publication number:
**WO 2022/172854 (18.08.2022 Gazette 2022/33)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.02.2021 JP 2021019113**

(71) Applicant: **Sony Group Corporation
Tokyo 108-0075 (JP)**

(72) Inventors:
• **IWAMURO, Ryo**
  **Tokyo 108-0075 (JP)**
• **KATO, Yusaku**
  **Tokyo 108-0075 (JP)**
• **SUZUKI, Takahito**
  **Tokyo 108-0075 (JP)**
• **MITSUHASHI, Hiroyuki**
  **Tokyo 108-0075 (JP)**
• **GOTO, Yoshio**
  **Tokyo 108-0075 (JP)**

(74) Representative: **D Young & Co LLP
120 Holborn
London EC1N 2DY (GB)**

(54) **ACTUATOR AND ELECTRONIC DEVICE**

(57)    An actuator having good interlayer adhesion at a lamination interface, good conductivity of an electrode layer, and good smoothness of the electrode layer is provided.

The actuator includes a plurality of elastomer layers and a plurality of electrode layers, and the elastomer layers and electrode layers are alternately laminated. The electrode layer contains carbon black, a content of the carbon black in the electrode layer is 10% by mass or more and 20% by mass or less, and a specific surface area of the carbon black is 380 $g/m^2$ or more and 800 $m^2/g$ or less.

Fig. 1

EP 4 293 892 A1

## Description

[Technical Field]

The present disclosure relates to an actuator and electronic equipment including the same.

[Background Art]

A soft actuator is a material, an element, or a device that functions as an actuator by deformation of a lightweight and flexible material, and has recently attracted attention as a next-generation actuator. A dielectric elastomer actuator (hereinafter referred to as "DEA") is one of soft actuators and is expected to be applied to various fields including soft robotics. A DEA has a basic structure constituted by an elastomer layer made of an insulating material and flexible electrode layers having the elastomer layer sandwiched therebetween, and is configured such that the elastomer layer is deformed due to electrostatic attraction of electric charge charged in the electrode layers by applying a voltage. A basic operation principle of the DEA is to take out the deformation of the elastomer layer as a displacement.

In the related art, in a DEA, a conductive material such as a carbon material has been used for an electrode layer. For example, PTL 1 discloses that, from the viewpoint of securing elasticity of an electrode, a filling rate of a conductive filler is preferably 25 vol% or less when the volume of the electrode is set to 100 vol%. Further, PTL 2 discloses that the content of a conductive material is preferably 50 parts by mass or less with respect to 100 parts by mass of a matrix in consideration of flexibility and conductivity of a flexible conductive material.

Among soft actuators, a DEA is characterized by a large displacement and a high volume power density, while a high electric field intensity is required during driving of the DEA, and thus there is a problem that a driving voltage is usually high. This is due to a displacement and a voltage that satisfy the following formula, and the displacement is proportional to the square of the voltage, and thus the displacement is greatly reduced when a voltage to be applied is lowered.

[Math. 1]

$$\Delta t_{max} = \varepsilon \frac{t}{Y} \left( \frac{V}{t} \right)^2$$

(However, symbols in the formula represent the following. $\Delta t_{max}$: Maximum displacement, $\varepsilon$: Dielectric constant of elastomer layer, t: Thickness of elastomer layer, Y: Elastic modulus of elastomer layer, V: Voltage)

[Citation List]

[Patent Literature]

[PTL 1]
JP 2010-43880A
[PTL 2]
JP 2016-69456A

[Summary]

[Technical Problem]

It is theoretically possible to solve the above problem by adopting a technique for thinning an elastomer layer and laminating a plurality of electrode layers and elastomer layers. However, the above technique has the following problems.

A first problem is adhesion at a lamination interface. As a laminated body manufacturing process with good mass productivity, a process of sequentially laminating composite sheets in which an electrode layer is patterned on an elastomer layer is conceivable, but adhesion at an interface between the composite sheets separately formed is generally low. As an improvement measure, a method of providing a separate binder layer is conceivable, but in that case, thinning becomes difficult. When adhesion is low, peeling is likely to occur between layers during a lamination process. In addition, peeling is likely to occur when operating as an actuator. For this reason, there is a concern that a defective product may be produced.

A second problem is conductivity of the electrode layer. When the actuator operates, the electrode layer is required to adhere to and follow the elastomer layer, and thus the electrode layer is desired to be flexible. In addition, in order to obtain good operational responsiveness, it is desired that the electrode layer have good conductivity. In order to impart flexibility to the electrode layer, a method of compositely forming the electrode layer with conductive particles and a flexible binder resin is conceivable. However, conductivity and flexibility generally have a trade-off relationship, and it is difficult to increase the conductivity of the electrode layer while maintaining the flexibility of the electrode layer.

A third problem is smoothness of the electrode layer. The thickness of the electrode layer is preferably approximately several pm from the viewpoint of conductivity and shape retention, but it is difficult to obtain a smooth thin film sheet containing highly cohesive nano-sized conductive particles. When the smoothness of the electrode layer is low, an electric field becomes non-uniform and dielectric breakdown is likely to occur.

An object of the present disclosure is to provide an actuator having good interlayer adhesion at a lamination interface, good conductivity of an electrode layer, and good smoothness of the electrode layer, and electronic equipment including the actuator.

[Solution to Problem]

In order to solve the above-described problems, a first disclosure is an actuator including a plurality of elastomer layers, and a plurality of electrode layers, in which the elastomer layers and the electrode layers are alternately laminated, the electrode layer contains carbon black, a content of the carbon black in the electrode layer is 10% by mass or more and 20% by mass or less, and a specific surface area of the carbon black is 380 $g/m^2$ or more and 800 $m^2/g$ or less.

A second disclosure is electronic equipment including the actuator according to the first disclosure.

[Brief Description of Drawings]

[Fig. 1]

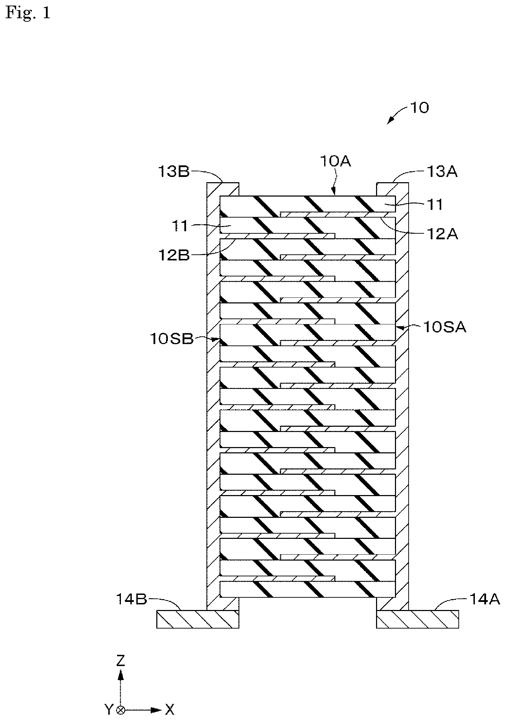

Fig. 1 is a cross-sectional view illustrating an example of a configuration of an actuator according to a first embodiment of the present disclosure.
[Fig. 2]

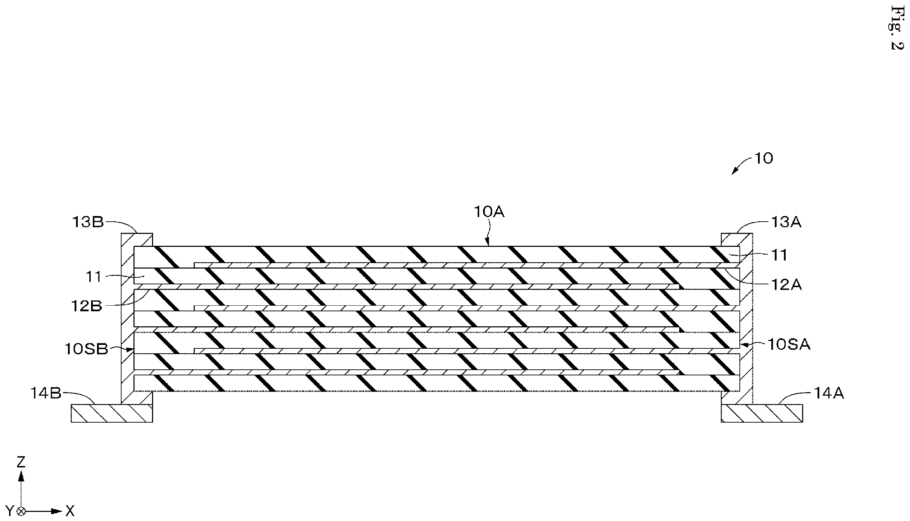

Fig. 2 is a cross-sectional view illustrating an example of a configuration of an actuator according to a modification example.
[Fig. 3]

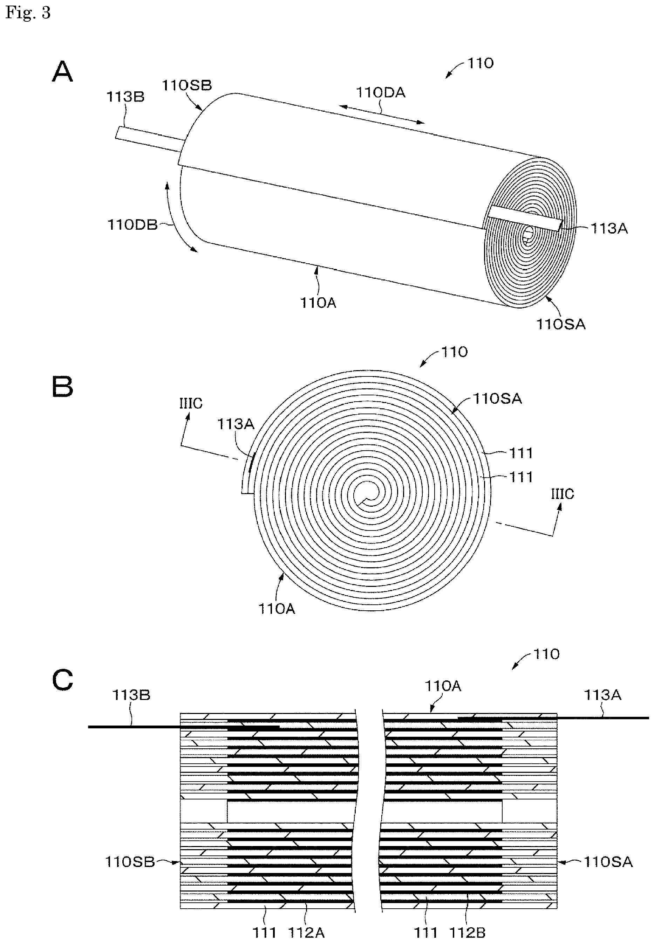

Fig. 3A is a perspective view illustrating an example of the appearance of an actuator according to a second embodiment of the present disclosure. Fig. 3B is a plan view illustrating an enlarged one end surface of the actuator illustrated in Fig. 3A. Fig. 3C is a cross-sectional view along line IIIC-IIIC in Fig. 3B.
[Fig. 4]

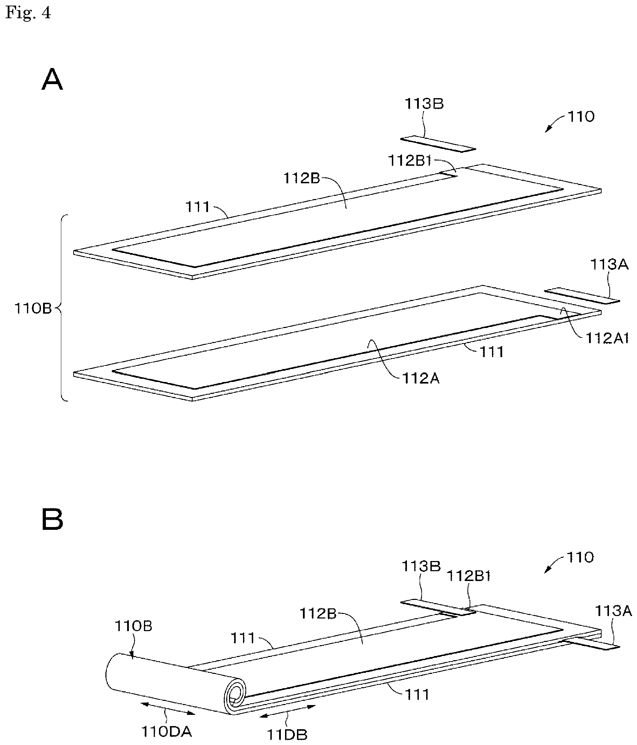

Fig. 4A is an exploded perspective view illustrating an example of an entire actuator that is unwound. Fig. 4B is an exploded perspective view illustrating an example of an actuator which is partially unwound.
[Fig. 5]

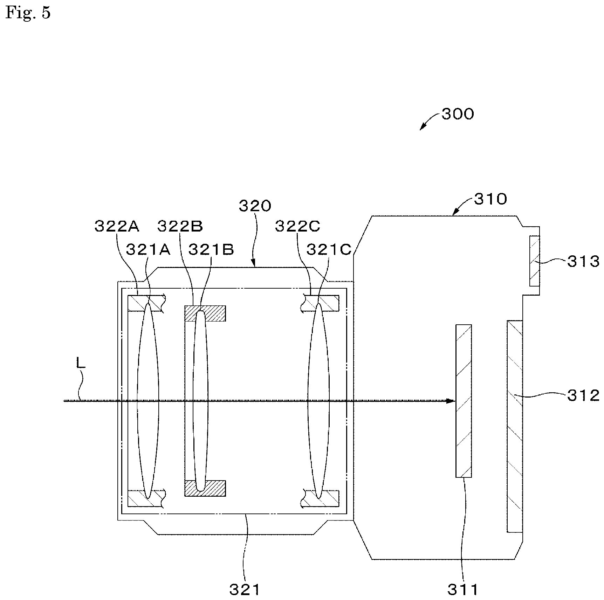

Fig. 5 is a cross-sectional view illustrating an example of a configuration of an imaging device as an application example.
[Fig. 6]

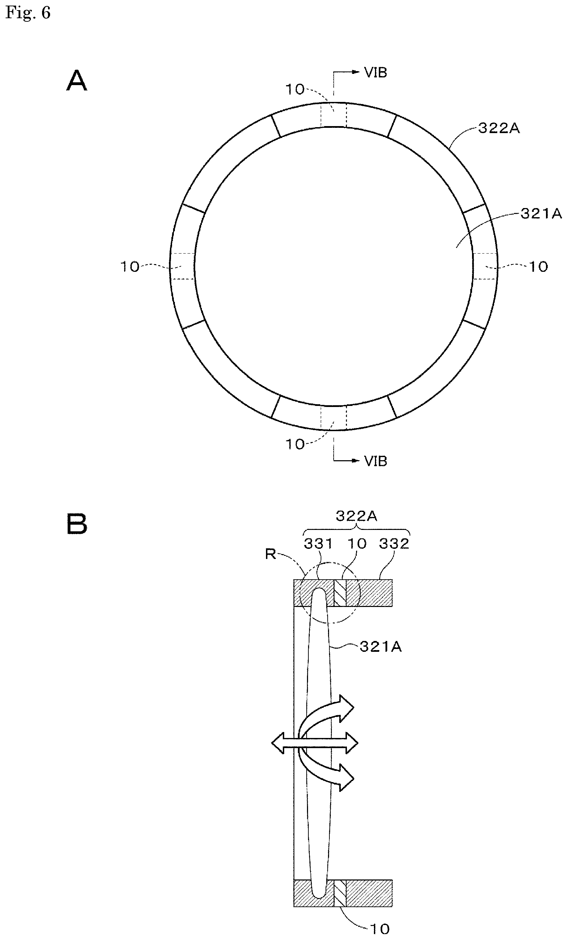

Fig. 6A is a plan view illustrating an example of a configuration of a lens and a holder for holding the lens. Fig. 6B is a cross-sectional view along line VIB-VIB in Fig. 6A.
[Fig. 7]

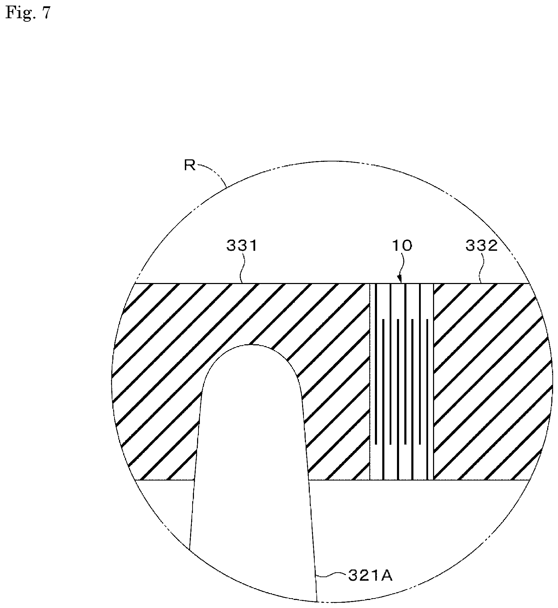

Fig. 7 is an enlarged cross-sectional view illustrating a region R in Fig. 6B.
[Fig. 8]

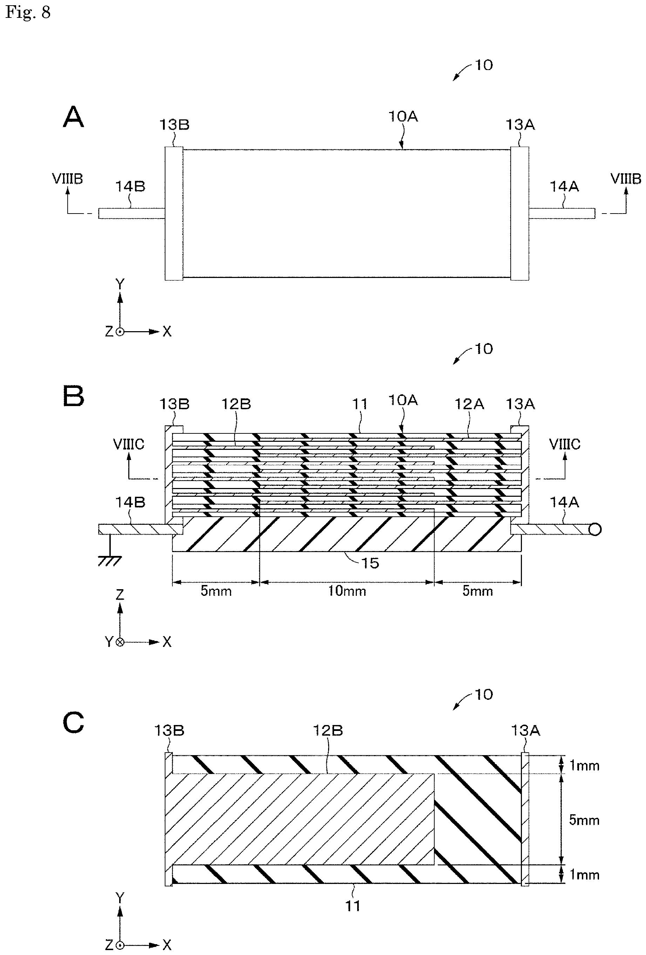

Fig. 8A is a plan view illustrating a configuration of an actuator according to Example 7. Fig. 8B is a cross-sectional view along line VIIIB-VIIIB in Fig. 8A. Fig. 8C is a cross-sectional view along line VIIIC-VIIIC in Fig. 8B.

[Description of Embodiments]

Embodiments and application examples of the present disclosure will be described in the following order. Note that, in all drawings of the following embodiments and application examples, the same or corresponding portions will be denoted by the same reference numerals.

    1. First Embodiment (example of actuator)
    2. Second Embodiment (example of actuator)
    3. Application Example (example of imaging device)

<1 First Embodiment>

[Configuration of Actuator]

An example of a configuration of an actuator 10 according to a first embodiment of the present disclosure will be described below with reference to Fig. 1. The actuator 10 is a laminated DEA. The actuator 10 includes a laminated body 10A, an external electrode 13A, an external electrode 13B, a lead-out electrode 14A, and a lead-out electrode 14B.

The actuator 10 can be applied to various driving devices or electronic equipment. Specific examples of driving devices to which the actuator 10 can be applied include lens driving devices (for example, an autofocus lens driving device for a camera), camera shake correction devices, vibration devices (for example, a tactile display, a vibrator, an acoustic transducer (speaker or the like)), artificial muscles, and the like, but are not limited thereto. Specific examples of electronic equipment to which the actuator 10 can be applied include personal computers, mobile equipment, mobile phones, tablet computers, display devices, imaging devices, audio equipment, game equipment, industrial tools, medical tools (for example, an endoscope), robots, and the like, but are not limited thereto.

(Laminated Body)

The laminated body 10A is the main body of the actuator 10. The laminated body 10A has a rectangular parallelepiped shape. The laminated body 10A has a first side surface 10SA and a second side surface 10SB facing the first side surface 10SA. However, the shape of the laminated body 10A is not limited thereto, and may be cylindrical, elliptical, prismatic, or the like. The laminated body 10A includes a plurality of elastomer layers 11, a plurality of electrode layers 12A, and a plurality of electrode layers 12B. In the following description, the electrode layer 12A and the electrode layer 12B are collectively referred to as the electrode layer 12 without any particular distinction. The plurality of elastomer layers 11 and the plurality of electrode layers 12 are laminated such that the elastomer layers 11 and the electrode layers 12 are alternately positioned.

In the present specification, first and second directions, which are in-plane directions of the elastomer layer 11 and are perpendicular to each other, are referred to as X-axis and Y-axis directions, respectively. In addition, a direction perpendicular to the principal surface of the elastomer layer 11, that is, a lamination direction of the elastomer layers 11 and the electrode layers 12 is referred to as a Z-axis direction. Note that, when the elastomer layer 11 has a rectangular shape, the longitudinal direction of the elastomer layer 11 is referred to as the X-axis direction, and the lateral direction (width direction) of the elastomer layer 11 is referred to as the Y-axis direction. From the viewpoint of insulation, both end surfaces in the Z-axis direction are preferably covered with the elastomer layer 11. The laminated body 10A is configured to be displaceable in the Z-axis direction by application of a driving voltage.

(Elastomer Layer)

The elastomer layer 11 is a dielectric elastomer layer and has elasticity in the in-plane directions (X-axis and Y-axis directions) of the actuator 10. Each elastomer layer 11 is sandwiched by a set of electrode layers 12. The elastomer layer 11 is, for example, a sheet. Note that, in this disclosure, the sheet is defined as including a film. Examples of the shape of the elastomer layer 11 in a plan view include a polygonal shape such as a rectangular shape, a circular shape, an elliptical shape, and the like, but the shape is not limited to these shapes. The elastomer layer 11 may be pre-strained (that is, biaxially stretched) in the X-axis and Y-axis directions.

The elastomer layer 11 contains, for example, an insulating elastomer serving as an insulating elastic material. The insulating elastomer includes, for example, at least one selected from a group consisting of silicone-based resins, acrylic-based resins, urethane-based resins, and the like.

The elastomer layer 11 may contain additives as needed. Additives include, for example, at least one selected from a group consisting of cross-linking agents, plasticizers, anti-aging agents, surfactants, viscosity modifiers, reinforcing agents, coloring agents, and the like.

A lower limit value of an average thickness of the elastomer layer 11 is preferably 1 pm or more. When the lower limit value of the average thickness of the elastomer layer 11 is 1 pm or more, handleability can be improved. An upper limit value of the average thickness of the elastomer layer 11 is preferably 20 pm or less. When the upper limit value of the average thickness of the elastomer layer 11 is 20 pm or less, a good displacement can be obtained with a low driving voltage.

The average thickness of the elastomer layer 11 is obtained as follows. First, the actuator 10 is cut parallel to the Z-axis direction (lamination direction) by razor force cutting to expose the cross-section thereof, Pt is sputtered to a thickness of approximately 2 nm, and then the cross-section of the specimen is observed by a scanning electron microscope (SEM). A device observation conditions are shown below.

Device: SEM (Helios G4 manufactured by Thermo Fisher)
Accelerating voltage: 5 kV
magnification: 1000 times

Next, after the thickness of the elastomer layer 11 is measured at least 10 points or more by using an obtained SEM image, measured values are simply averaged (arithmetic average) to obtain an average thickness of the elastomer layer 11. Note that it is assumed that measurement positions are randomly selected from the specimen.

It is preferable that the Young's modulus of the elastomer layer 11 is equal to or less than the Young's modulus of the electrode layer 12. When the Young's modulus of the elastomer layer 11 is equal to or less than the Young's modulus of the electrode layer 12, the displacement of the actuator 10 can be improved. A lower limit value of the Young's modulus of the elastomer layer 11 is preferably 0.05 MPa or more. When the lower limit value of the Young's modulus of the elastomer layer 11 is 0.05 MPa or more, the handleability of the elastomer layer 11 can be improved. The upper limit value of the Young's modulus of the elastomer layer 11 is preferably 5 MPa or less. When the upper limit value of the Young's modulus of the elastomer layer 11 is 5 MPa or less, a good displacement can be obtained with a low driving voltage.

The Young's modulus of the elastomer layer 11 is obtained as follows. An interface between the elastomer layer 11 and the electrode layer 12 is separated to take out the elastomer layer 11. Subsequently, after tensile characteristics of the elastomer layer 11 are obtained in accordance with JIS K 6251:2010, the Young's modulus of the elastomer layer 11 is obtained from a ratio of tensile stress within a range in which stress changes linearly with respect to strain (that is, a range in which a linear response is obtained) and the corresponding strain. The above tensile characteristics are measured under an environment of a temperature of 25°C and a humidity of 50% RH. Note that, unless otherwise specified, each measurement to be described below is also performed under an environment of a temperature of 25°C and a humidity of 50% RH.

(Electrode)

The electrode layer 12 has elasticity in an in-plane direction (X-axis and Y-axis directions) of the actuator 10. Thereby, the electrode layer 12 can expand and contract following the expansion and contraction of the elastomer layer 11. The elastomer layer 11 is sandwiched between the electrode layers 12 adjacent to each other in the Z-axis direction. The electrode layers 12 overlap each other in the Z-axis direction. Examples of the shape of the electrode layer 12 in a plan view include a polygonal shape such as a rectangular shape, a circular shape, an elliptical shape, and the like, but the shape is not limited to these shapes.

The electrode layer 12 contains carbon black and a binder. Carbon black is a conductive material for imparting conductivity to the electrode layer 12. Carbon black is so-called conductive carbon black. A lower limit value of the content of the carbon black in the electrode layer 12 is 10% by mass or more. When the content of the carbon black in the electrode layer 12 is less than 10% by mass, the electrical conductivity of the electrode layer 12 is lowered. An upper limit value of the content of the carbon black in the electrode layer 12 is 20% by mass or less. When the upper limit value of the content of the carbon black in the electrode layer 12 exceeds 20% by mass, the amount of binder in the electrode layer 12 is excessively reduced, and thus sufficient interlayer adhesion between the elastomer layer 11 and the electrode layer 12 cannot be obtained.

The content of the carbon black in the electrode layer 12 is determined as follows. The interface between the elastomer layer 11 and the electrode layer 12 is separated to take out the electrode layer 12. When the separation is difficult, a surface is scraped off by a surface and interfacial cutting analysis system (SAICAS) method, and the portion of the electrode layer 12 is recovered. After the total mass of the taken out electrode layer 12 is measured, a silicone resin of the binder is dissolved by a MOF decomposition method (methyl orthoformate decomposition method) to recover an inorganic material (carbon black). The mass of the inorganic material is measured, and the content of carbon in the electrode layer 12 is calculated from the values of the total mass and the mass of the inorganic material.

A lower limit value of the specific surface area of carbon black is 380 g/m$^2$ or more. When the specific surface area is less than 380 g/m$^2$, contact points between the carbon blacks are reduced, and thus the conductivity of the electrode layer 12 is lowered. An upper limit value of the specific surface area of carbon black is 800 m$^2$/g or less. When the specific surface area exceeds 800 m$^2$/g, the carbon black tends to aggregate and the smoothness of the surface of the electrode layer 12 decreases.

The specific surface area of the above-mentioned carbon black is obtained as follows. Carbon black is recovered from the electrode layer 12 in the same manner as the method of obtaining the content of the carbon black in the electrode layer 12 described above. The specific surface area of the recovered carbon black is obtained by a BET method. The specific surface area is specifically measured according to JIS K 6217-2. A measurement device and measurement conditions are shown below.

Measuring device: BELSORP-max2 manufactured by Microtrack Bell
Measured adsorbate: $N_2$ gas
Measurement pressure range (p/p0): 0.01 to 0.99

It is preferable that carbon black have a porous structure. Carbon black having a porous structure can increase the specific surface area of carbon black. Thus, the conductivity of the electrode layer 12 can be improved. Carbon black includes, for example, at least one selected from a group consisting of ketjen black and acetylene black.

The binder has elasticity. It is preferable that the binder be an insulating elastomer. The insulating elastomer includes, for example, at least one selected from a group consisting of silicone-based resins, acrylic-based resins, urethane-based resins, and the like.

The electrode layer 12 may further contain additives as needed. Examples of the additives include those similar to those for the elastomer layer 11. Since a dispersant may adversely affect the characteristics of the electrode layer 12, it is preferable that the electrode layer 12 do not contain a dispersant as an additive.

An upper limit value of an electrical resistivity of the electrode layer 12 is preferably 30.0 Q cm or less, more preferably 25.8 Q cm or less. When the upper limit value of the electrical resistivity of the electrode layer 12 is 30.0 Q cm or less, good operational responsiveness can be obtained. A lower limit value of the electrical resistivity of the electrode layer 12 is preferably 0.1 Q cm or more, more preferably 0.9 Q cm or more. When the lower limit value of the electrical resistivity of the electrode layer 12 is 0.1 Q cm or more, an excessive decrease in the amount of binder in the electrode layer 12 can be suppressed, and thus sufficient interlayer adhesion between the elastomer layer 11 and the electrode layer 12 can be obtained.

The electrical resistivity of the electrode layer 12 is obtained as follows. A sample in which the surface of the electrode layer 12 is exposed is obtained by peeling or removing a part of the laminated body 10A. Thereafter, the sample is cut such that the electrode layer 12 has a rectangular shape with a width of 10 mm $\times$ a length of 50 mm, thereby obtaining a sample for evaluation. However, when it is difficult to take out a sample having the above-mentioned size, it is assumed that a sample having a size that can be taken out is taken out. Subsequently, a DC resistance of the electrode layer 12 of the evaluation sample is measured by using a digital multimeter 117 manufactured by Fluke Corporation to calculate an electrical resistivity.

A lower limit value of an average thickness of the electrode layer 12 is preferably 0.5 pm or more, more preferably 1 pm or more. When the lower limit value of the average thickness of the electrode layer 12 is 0.5 pm or more, good operational responsiveness can be obtained, and good interlayer adhesion can be obtained between the elastomer layer 11 and the electrode layer 12. An upper limit value of the average thickness of the elastomer layer 11 is preferably 20 pm or less, more preferably 10 pm or less. When the upper limit value of the average thickness of the elastomer layer 11 is 20 pm or less, a good displacement can be obtained.

The average thickness of the electrode layer 12 is obtained by the same method as for the average thickness of the elastomer layer 11.

A lower limit value of the Young's modulus of the electrode layer 12 is preferably 0.1 MPa or more. When the lower limit value of the Young's modulus of the electrode layer 12 is 0.1 MPa or more, handleability can be improved. The upper limit value of the Young's modulus of the electrode layer 12 is preferably 5 MPa or less. When the upper limit value of the Young's modulus of the electrode layer 12 is 5 MPa or less, a good displacement can be obtained.

The Young's modulus of the electrode layer 12 can be obtained in the same manner as the Young's modulus of the elastomer layer 11 except that an interface between the elastomer layer 11 and the electrode layer 12 is separated and the electrode layer 12 is taken out.

(External Electrode)

The external electrode 13A is used to electrically connect the plurality of electrode layers 12A. It is preferable that the external electrode 13A have elasticity in the Z-axis direction. Thereby, the external electrode 13A can be deformed following expansion and contraction of the laminated body 10A. The external electrode 13A is provided on a first side surface 10SA of the laminated body 10A. Ends of the plurality of electrode layers 12A are connected to the external electrode 13A.

The external electrode 13B is used to electrically connect the plurality of electrode layers 12B. It is preferable that the external electrode 13B have elasticity in the Z-axis direction. Thereby, the external electrode 13B can be deformed following expansion and contraction of the laminated body 10A. The external electrode 13B is provided on a second side surface 10SB of the laminated body 10A. Ends of the plurality of electrode layers 12B are connected to the external electrode 13B.

The external electrodes 13A and 13B contain a conductive material. As the conductive material, the same materials as those of the electrode layers 12A and 12B can be exemplified. The external electrodes 13A and 13B may contain a binder having elasticity as needed. It is preferable that the binder is an elastomer. As the elastomer, the same one as the elastomer layer 11 can be exemplified.

(Lead-Out Electrode)

The lead-out electrodes 14A and 14B are used to connect the actuator 10 to a voltage source of electronic equipment. The lead-out electrode 14A is connected to the external electrode 13A. The lead-out electrode 14B is connected to the external electrode 13B. The lead-out electrodes 14A and 14B are made of, for example, a metal.

(Displacement Rate of Actuator)

A displacement rate of the actuator 10 in the lamination direction when a driving voltage of 300 V is applied is preferably 0.5% or more, more preferably 1.0% or more. When the displacement rate in the lamination direction is 0.5% or more, the actuator 10 can be applied to various types of driving devices, various types of electronic equipment, and the like. The above-mentioned displacement rate is obtained by the following formula.

$$\text{Displacement rate } [\%] = ((D_2 - D_1)/D_1) \times 100$$

(Wherein symbols in the formula represent the following. $D_1$: thickness of actuator 10 when driving voltage is not applied, $D_2$: thickness of actuator 10 when driving voltage of 300 V is applied)

Note that the thickness $D_1$ of the actuator 10 is measured by a contact film thickness measuring device manufactured by Mitutoyo Corporation. $D_2$-$D_1$ is measured by using a laser displacement meter LK-G500 from Keyence Corp. based on changes in a distance between the surface of the actuator and the displacement meter when a voltage is applied.

[Operation of Actuator]

An example of the operation of the actuator 10 according to the first embodiment of the present disclosure will be described below.

When a driving voltage is applied between the electrode layers 12A and 12B, an attractive force due to the Coulomb force acts between the electrode layers 12A and 12B with the elastomer layer 11 interposed therebetween. For this reason, the elastomer layer 11 is compressed in its thickness direction (Z-axis direction) and becomes thinner. Thus, the actuator 10 contracts in the Z-axis direction.

On the other hand, when the driving voltage applied between the electrode layers 12A and 12B with the elastomer layer 11 interposed therebetween is canceled, an attractive force due to the Coulomb force does not act between the electrode layers 12A and 12B. For this reason, compression is canceled, and the elastomer layer 11 returns to its original thickness. Thus, the actuator 10 expands in the Z-axis direction.

As described above, in the actuator 10 according to the first embodiment, the actuator 10 can be displaced in the Z-axis direction by applying and canceling a driving voltage between the electrode layers 12A and 12B. Note that, when the actuator 10 is applied to various driving devices or electronic equipment, a default state (initial state) of the actuator 10 may be a state where a predetermined voltage is applied to the actuator 10, or may be a state where no voltage is applied.

[Method of Manufacturing Actuator]

An example of a method of manufacturing the actuator 10 according to the first embodiment of the present disclosure will be described below.

(Conductive Paste Preparation Process)

A conductive paint is prepared by adding and dispersing carbon black and a binder in a solvent. At this time, if necessary, an additive may be added to the solvent. The conductive paint may be conductive ink or conductive paste.

As a dispersion method, it is preferable to use stirring, ultrasonic dispersion, bead dispersion, kneading, homogenizer treatment, or the like. These dispersion methods may be used alone or in combination of two or more. The solvent is not particularly limited as long as it can disperse the elastomer. Examples thereof include water, ethanol, methyl ethyl ketone, isopropanol alcohol, acetone, anones (cyclohexanone, cyclopentanone), hydrocarbons (hexane), amides (DMF), sulfides (DMSO), butyl cellosolve, butyl triglycol, propylene glycol monomethyl ether, propylene glycol monoethyl ether, ethylene glycol monoethyl ether, ethylene glycol monopropyl ether, ethylene glycol monoisopropyl ether, diethylene glycol monobutyl ether, diethylene glycol monoethyl ether, diethylene glycol monomethyl ether, diethylene glycol diethyl ether, dipropylene glycol monomethyl ether, tripropylene glycol monomethyl ether, propylene glycol monobutyl ether, propylene glycol isopropyl ether, dipropylene glycol isopropyl ether, tripropylene glycol isopropyl ether, methyl glycol, terpineol, butyl carbitol acetate, and the like. These solvents may be used alone or in combination of two or more.

(Electrode Formation Process)

Next, a conductive paint is applied onto the elastomer layer 11 to form the electrode layer 12. Thereby, an electrode sheet is obtained. Screen printing, intaglio printing, or letterpress printing is preferable as a method of applying an electrode forming paint.

(Lamination Process)

Next, after two electrode sheets are superimposed on each other, the two electrode sheets are bonded together by hot pressing. By repeating this process, the laminated body 10A in which a plurality of electrode sheets are laminated is obtained. However, the lamination process is not limited to the above-mentioned process, and the laminated body 10A may be obtained by laminating all of the electrode sheets and then performing hot pressing thereon.

(External Electrode Formation Process)

Next, an electrode paste is applied to the first side surface 10SA and the second side surface 10SB of the laminated body 10A to form the external electrodes 13A and 13B. Next, the lead-out electrodes 14A and 14B are connected to the external electrodes 13A and 13B, respectively. Thereby, the actuator 10 illustrated in Fig. 1 is obtained.

[Operational Effects]

As described above, the actuator 10 according to the first embodiment includes the plurality of elastomer layers 11 and the plurality of electrode layers 12, and the elastomer layers 11 and electrode layers 12 are alternately laminated. Thereby, a large displacement can be obtained at a low voltage.
The electrode layer 12 contains carbon black as conductive particles, and thus the weight of the actuator 10 can be reduced. In addition, the cost of the actuator 10 can be reduced as compared with a case where the electrode layer 12 contains carbon nanotubes (CNT) or metal nanoparticles as conductive particles.
The content of the carbon black in the electrode layer 12 is 10% by mass or more and 20% by mass or less, and a specific surface area of carbon black is 380 $g/m^2$ or more and 800 $m^2/g$ or less. Thereby, it is possible to obtain the actuator 10 having good interlayer adhesion at a lamination interface, good conductivity of the electrode layer 12 and good smoothness of the electrode layer 12.
When the interlayer adhesion at the lamination interface is good, the actuator 10 with excellent operating characteristics and good yield can be obtained. When the conductivity of the electrode layer 12 is good, the actuator 10 with excellent responsiveness can be obtained. When the smoothness of the electrode layer 12 is good, the actuator 10 with an excellent withstand voltage can be obtained.
When the interlayer adhesion at the lamination interface is good, it is possible to secure the interlayer adhesion at the lamination interface without separately providing a binder layer between the electrode layer 12 and the elastomer layer 11. This facilitates lamination of thin films, and thus a large displacement can be secured at a low voltage.
Since carbon black has a specific surface area of 800 $m^2/g$ or less, dispersibility of the carbon black can be secured without a dispersant. That is, the electrode layer 12 with good smoothness can be obtained without adding a dispersant. Since a dispersant may adversely affect the characteristics of the electrode layer 12, it is preferable that the electrode layer 12 do not contain a dispersant.
When the electrode layer 12 contains a silicone-based resin as a binder, it is possible to obtain the electrode layer 12 having flexibility, good heat resistance, and chemical stability.

[Modification Example]

In the above-described first embodiment, an example in which the actuator 10 is configured to be displaceable in the Z-axis direction (see Fig. 1) has been described, but the actuator 10 may be configured to be displaceable in the X-axis and Y-axis directions as illustrated in Fig. 2.

<2 Second Embodiments

[Configuration of Actuator]

An example of a configuration of an actuator 110 according to a second embodiment of the present disclosure will be described below with reference to Figs. 3A to 3C, 4A, and 4B. The actuator 110 includes a wound body 110A, a lead-out electrode 113A, and a lead-out electrode 113B.

The wound body 110A has a substantially columnar shape. The wound body 110A is the main body of the actuator 110 and is constituted by a wound laminated body 110B. The laminated body 110B includes two elastomer layers 111 and two electrode layers 112A and 112B. In the following description, the electrode layer 112A and the electrode layer 112B are collectively referred to as the electrode layer 112 without particular distinction.

The two elastomer layers 111 and the two electrode layers 112 are laminated such that the elastomer layers 111 and the electrode layers 112 are alternately positioned. More specifically, the elastomer layer 111, the electrode layer 112A, the elastomer layer 111, and the electrode layer 112B are laminated in that order.

(Elastomer Layer)

The elastomer layer 111 is the same as the elastomer layer 11 in the first embodiment except that it has a belt shape and can be wound in the longitudinal direction. The elastomer layer 111 may be pre-strained (that is, biaxially stretched) in a central axial direction 110DA and a circumferential direction 110DB of the wound body 110A.

(Electrode Layer)

The electrode layer 112A is sandwiched between the two elastomer layers 111 in an unwound state. The electrode layer 112A has a belt shape and can be wound in the longitudinal direction. The electrode layer 112A has an extended portion 112A1. The extended portion 112A1 extends from one long side of the electrode layer 112A. The electrode layer 112A is the same as the electrode layer 12A in the first embodiment except for the above exceptional points.

The electrode layer 112B is provided on the elastomer layer 111 that is on the inner side of the laminated body 10A when wound. The electrode layer 112B has a belt shape and can be wound in the longitudinal direction. The electrode layer 112B has an extended portion 112B 1. The extended portion 112B 1 extends from the other long side of the electrode layer 112B. The electrode layer 112A is the same as the electrode layer 12B in the first embodiment except for the above exceptional points.

(Lead-Out Electrode)

The lead-out electrodes 113A and 113B are used to connect the actuator 110 to a voltage source of electronic equipment. The lead-out electrode 113A is led out from one end surface 110SA of the wound body 110A. The lead-out electrode 113A is connected to the extended portion 112A1 by welding or the like. The lead-out electrode 113B is led out from the other end surface 110SB of the wound body 110A. The lead-out electrode 113B is connected to the extended portion 112B1 by welding or the like.

Although Fig. 3 and the like illustrate an example in which the lead-out electrodes 113A and 113B are led out from the outer peripheral side of the wound body 110A, lead-out positions of lead-out electrodes 113A and 113B are not limited to this example, and the lead-out electrodes 113A and 113B can be led out from any position (for example, the inner peripheral side) of the wound body 110A.

[Operation of Actuator]

An example of the operation of the actuator 10 according to the second embodiment of the present disclosure will be described below.

When a driving voltage is applied between the electrode layers 112A and 112B, the elastomer layer 11 sandwiched between the electrode layers 12A and 12B is compressed in its thickness direction and becomes thinner. Thereby, the actuator 10 extends in the central axial direction 110DA of the wound body 110A.

On the other hand, when the driving voltage applied between the electrode layers 12A and 12B is canceled, the elastomer layer 11 sandwiched between the electrode layers 12A and 12B returns to its original thickness. Thereby, the actuator 10 contracts in the central axial direction 110DA of the wound body 110A.

[Operational Effects]

In the actuator 110 according to the second embodiment, the same effect as those of the actuator 10 according to the first embodiment can be obtained.

<3 Application Example>

Fig. 5 is a cross-sectional view illustrating an example of a configuration of an imaging device 300 as an application example. The imaging device 300 is a so-called single-lens reflex camera, and includes a camera body 310 and an imaging lens 320 configured to be attached to or detached from the camera body 310. The imaging device 300 is an example of electronic equipment.

(Camera Body)

The camera body 310 includes an imaging element 311, a monitor 312, an electronic viewfinder 313, and the like. The imaging element 311 photoelectrically converts a subject light image formed by incident light L passing through the imaging lens 320 to generate a captured image signal. The imaging element 311 is constituted by, for example, a CCD image sensor or a CMOS image sensor.

The captured image signal output from the imaging element 311 is subjected to image processing such as resolution conversion performed by an image processing unit which is not illustrated in the drawing, and is then displayed on the monitor 312 and the electronic viewfinder 313. Further, when a shutter button is pressed, the captured image signal is subjected to compression processing and recording encoding processing and is then stored in a recording medium which is not illustrated in the drawing.

The monitor 312 and the electronic viewfinder 313 are constituted by a display device such as an organic electro-luminescence (EL) display or a liquid crystal display.

(Imaging Lens)

The imaging lens 320 includes a lens optical system 321, a lens control unit (not illustrated), and the like. The lens optical system 321 includes a plurality of lenses 321A, 321B, and 321C, and a plurality of holders (supporting members) 322A, 322B, and 322C that respectively support these lenses 321A, 321B, and 321C. The holder 322A includes a plurality of actuators 10 according to the first embodiment, and supports the lens 321A via these actuators 10.

Fig. 6A is a plan view illustrating examples of configurations of the lens 321A and the holder 322A that holds the lens 321A. Fig. 6B is a cross-sectional view along VIB-VIB in Fig. 6A. Fig. 7 is an enlarged cross-sectional view illustrating a region R in Fig. 6B. The lens 321A is an autofocus lens. The holder 322A includes a lens support portion 331, a plurality of actuators 10, and a holder body 332.

The lens support portion 331 has a ring shape. The lens support portion 331 supports the lens 321A on an inner circumferential surface thereof. A driven body is constituted by the lens support portion 331 and the lens 321A. The holder body 332 has a ring shape. The holder body 332 supports the lens support portion 331 via the plurality of actuators 10. The holder body 332 is an example of a base material that supports the driven body constituted by the lens support portion 331 and the lens 321A.

The actuator 10 is an autofocus actuator. The actuator 10 moves the lens 321A in an optical axial direction of the incident light L. One principal surface of the actuator 10 is fixed to the lens support portion 331. The other principal surface of the actuator 10 is fixed to the holder body 332.

The actuator 10 may be configured by laminating 100 elastomer layers having an average thickness of 10 pm and 100 electrode layers 12 having an average thickness of 5 pm and packaging them. A driving voltage of the actuator 10 is, for example, 300 V

The lens 321C is a shake correction lens. The holder 322C includes a shake correction actuator (not illustrated). The shake correction actuator moves the lens 321C in a plane perpendicular to the optical axis of the incident light L.

The lens control unit controls the autofocus actuator 10 and the shake correction actuator.

[Examples]

Hereinafter, the present disclosure will be described below in detail with reference to examples, but the present disclosure is not limited to these examples.

In Examples 1 to 6 and Comparative Examples 1 to 10 below, electrode layers are formed using electrode pastes having different compositions, and the characteristics of the electrode layers are variously evaluated.

[Examples 1 to 3, Comparative Examples 1 and 2]

First, a silicone elastomer (manufactured by Dow Toray CO. Ltd., product name: MS1003A) and carbon black having a BET specific surface area of 380 g/m$^2$ (manufactured by Lion Specialty Chemicals CO. Ltd., product name: Lionite EC200L) were weighed, diluted with octamethyltrisiloxane, and stirred by a planetary mixer at 1500 rpm for 10 minutes to obtain an agitated liquid. Subsequently, a different type of silicone elastomer (manufactured by Dow Toray CO. Ltd., product name: MS1003B) was added to the agitated liquid with the same amount as the silicone elastomer (manufactured by Dow Toray CO. Ltd., product name: MS1003A) and stirred at 1500 rpm for one minute to obtain an electrode paste. The blending amounts of the carbon black and the silicone elastomer in the above process were carbon:silicone elastomer (mass ratio) = 5:95 (Comparative Example 1), 10:90 (Example 1), 15:85. (Example 2), 20:80 (Example 3), and 25:75 (Comparative Example 2) as shown in Table 1, and were adjusted such that the solid content concentration of the electrode paste was set to 20% by mass.

[Examples 4 to 6, Comparative Examples 3 and 4]

An electrode paste was obtained in the same manner as in Examples 1 to 3 and Comparative Examples 1 and 2 except that carbon black having a BET specific surface area of 800 g/m$^2$ (manufactured by Lion Specialty Chemicals Co., Ltd., product name: Ketjen black EC300J) was used instead of carbon black having a BET specific surface area of 380 g/m$^2$.

[Comparative Examples 5 to 7]

An electrode paste was obtained in the same manner as in Examples 1 to 3 except that carbon black having a BET specific surface area of 1400 g/m$^2$ (manufactured by Lion Specialty Chemicals Co., Ltd., product name: Ketjen black EC600JD) was used instead of carbon black having a BET specific surface area of 380 g/m$^2$.

[Comparative Examples 8 to 10]

An electrode paste was obtained in the same manner as in Examples 1 to 3 except that carbon black having a BET specific surface area of 220 g/m$^2$ (manufactured by Mitsubishi Chemical Corporation, product name: Ketjen black #3230B) was used instead of carbon black having a BET specific surface area of 380 g/m$^2$.

[Characteristic Evaluation]

The following characteristics were evaluated using the electrode paste obtained as described above. Note that the following evaluation was performed under an environment in which a temperature is 25°C, and a humidity is 50%RH.

(Evaluation of Interlayer Adhesion)

An electrode paste was screen-printed on a separately prepared square silicone elastomer sheet with a thickness of 35 pm and a vertical width of 10 cm × a horizontal width of 10 cm to form a rectangular electrode layer with a thickness of 5 pm and a width of 10 mm × a length of 30 mm, and plasma treatment was performed on the surface of the electrode layer. Thereafter, the silicone elastomer sheet was bonded to another silicone elastomer sheet of which the surface was similarly subjected to plasma treatment, and hot pressing was performed at a pressure of 2 MPa and a temperature of 110°C for 10 minutes to obtain an integrated sheet. Thereafter, adhesive tapes were attached to the front and back of the integrated sheet, and the integrated sheet was cut into a rectangular shape with a width of 8 mm × a length of 50 mm to obtain a sample for evaluation. A T-shaped peeling test was performed using the sample for evaluation to measure a peeling strength. The speed of peeling was set to 300 mm/s, and Autograph AGS-500NX manufactured by Shimadzu Corporation was used as a device. As the peeling strength, an arithmetic mean value at a peeling stroke of 15 mm to 30 mm was used. The results are shown in Table 1.

(Evaluation of Smoothness of Electrode Layer)

The electrode paste was blade-coated on a PET substrate with a gap of 110 pm to form a rectangular electrode layer having a thickness of 17 pm and a width of 10 mm × a length of 50 mm. Thereby, an electrode sheet with a thickness of 17 pm was obtained. The thickness of the obtained electrode sheet was measured in a range of 5 mm in the width direction using a contact-type profiler (P-16+) manufactured by KLA-Tencor Corporation, and an arithmetic mean roughness Ra was calculated. The results are shown in Table 1.

(Quality of Electrode Layer)

The sample manufactured in the above-mentioned smoothness evaluation of the electrode layer was observed at a magnification of 100 times for one field of view (3 mm × 2.2 mm) by using an optical microscope to confirm whether there is a crack in the electrode layer. When no crack was observed in the electrode layer, the quality of the electrode layer was determined to be "good". On the other hand, when a crack was found in the electrode layer, the quality of the electrode layer was determined to be "poor". The results are shown in Table 1. Note that, in Table 1, an evaluation result "good" is indicated by a symbol "○", and an evaluation result "poor" is indicated by "x".

(Evaluation of Conductivity)

An electrical resistivity of the electrode layer was obtained in the same manner as in the first embodiment, except that a sample manufactured in the above-mentioned smoothness evaluation of the electrode layer was used. The results are shown in Table 1.

[Table 1]

| | Comparative Example 1 | Example 1 | Example 2 | Example 3 | Comparative Example 2 | Comparative Example 3 | Example 4 | Example 5 | Example 6 | Comparative Example 4 | Comparative Example 5 | Comparative Example 6 | comparative Example 7 | Comparative Example 8 | Comparative Example 9 | Comparative Example 10 |
|---|---|---|---|---|---|---|---|---|---|---|---|---|---|---|---|---|
| Product Name of Carbon | EC200L | | | | | | EC300J | | | | | EC600JD | | | #32308 | |
| Type of Carbon | Porous | | | | | | Porous | | | | | Porous | | | Nonporous | |
| Specific Surface Area of Carbon (m²/g) | 380 | | | | | | 800 | | | | | 1400 | | | 220 | |
| Content of Carbon (% By Mass) | 5 | 10 | 15 | 20 | 25 | 5 | 10 | 15 | 20 | 25 | 10 | 15 | 20 | 10 | 15 | 20 |
| Content of Elastomer (% By Mass) | 95 | 90 | 85 | 80 | 75 | 95 | 90 | 85 | 80 | 75 | 90 | 85 | 80 | 90 | as | so |
| Interlayer Adhesion (mN/8mm) | 358 | 334 | 478 | 298 | 90 | 389 | 421 | 401 | 278 | 87 | - | - | - | - | - | - |
| Quality of Electrode Layer | ○ | ○ | ○ | ○ | × | ○ | ○ | ○ | ○ | × | ○ | × | × | ○ | ○ | ○ |
| Smoothness Ra (μm) | 0.19 | 0.52 | 0.69 | 0.56 | - | 0.56 | 0.9 | 0.61 | 0.57 | - | 1.1 | - | - | 0.12 | 0.22 | 0.39 |
| Electrical Resistivity (Ωcm) | >1000 | 25.8 | 3.8 | 1.6 | - | >1000 | 10.8 | 1.8 | 0.9 | - | 4.1 | - | - | >1000 | >1000 | 119 |

In Table 1, an evaluation result of an electricial resistivity ">1000" indicates that an evaluation result of an electrical resistivity was greater than 1000Ω cm.

Table 1 shows the following.

When the content of the carbon black in the electrode layer is 10% by mass or more than 20% by mass or less, and a specific surface area of carbon black is 380 g/m$^2$ or more and 800 m$^2$/g or less, interlayer adhesion at an lamination interface, the conductivity of the electrode layer, and the smoothness of the electrode layer are good (see Examples 1 to 6).

Even when the specific surface area of carbon black is 380 g/m$^2$ or more and 800 m$^2$/g or less, and when the content of the carbon black in the electrode layer is less than 10% by mass, the conductivity of the electrode layer is reduced (see Comparative Examples 1 and 3).

Even when the specific surface area of carbon black is 380 g/m$^2$ or more and 800 m$^2$/g or less, and when the content of the carbon black in the electrode layer exceeds 20% by mass, the interlayer adhesion at the lamination interface is reduced (see Comparative Examples 2 and 4).

Even when the content of the carbon black in the electrode layer is 10% by mass or more and 20% by mass or less, and when the specific surface area of carbon black is less than 380 g/m$^2$, conductivity is reduced (see Comparative Examples 8, 9, and 10).

Even when the content of the carbon black in the electrode layer is 10% by mass or more and 20% by mass or less, and when the specific surface area of carbon black exceeds 800 m$^2$/g, the carbon black tends to aggregate, resulting in low smoothness of the electrode layer. In addition, electrode quality is also degraded (see Comparative Examples 5, 6, and 7).

In Example 7 below, an actuator was manufactured by alternately laminating elastomer layers and electrode layers, and a displacement during driving was evaluated. Note that, in the actuator according to Example 7, portions corresponding to those of the actuator according to the first embodiment are denoted by the same reference numerals.

[Example 7]

First, ten electrode sheets each of which is constituted by a rectangular elastomer layer 11 with a thickness of 10 pm and a rectangular electrode layer 12 with a thickness of 5 pm were prepared, and these electrode sheets are sequentially laminated by hot pressing (2 MPa, 110°C, 10 minutes) to manufacture a laminated body 10A. At this time, the ten electrode sheets were laminated such that the number of electrode layers 12 was ten and the number of elastomer layers 11 was eleven. Next, excess margins were cut, and an electrode paste was applied to the opposing side surfaces to form external electrodes 13A and 13B. Thereafter, lead-out electrodes 14A and 14B constituted by an aluminum tape were connected to the external electrodes 13A and 13B, respectively, and then an adhesive tape 15 was attached to the principal surface of a laminated body 10A to cover the lead-out electrodes 14A and 14B. Thereby, an actuator 10 illustrated in Figs. 8A, 8B, and 8C was obtained.

(Displacement During Driving)

A driving voltage of 300 V was applied to the actuator 10 obtained as described above via the lead-out electrodes 14A and 14B, and a displacement in the Z-axis direction (thickness direction of the laminated body 10A) was measured. As a result, a displacement rate in the Z-axis direction when a driving voltage of 300 V was applied was 1.8%. Note that no delamination was observed after operation.

While the first and second embodiments of the present disclosure have been described above in detail, the present disclosure is not limited to the above first and second embodiments, and various modifications can be made based on the technical idea of the present disclosure.

For example, the configurations, methods, processes, shapes, materials, numerical values and the like exemplified in the above first and second embodiments are only examples, and as necessary, different configurations, methods, processes, shapes, materials, numerical values and the like may be used.

The configurations, methods, processes, shapes, materials, numerical values, and the like of the above-described first and second embodiments can be combined with each other without departing from the gist of the present disclosure.

In addition, unless otherwise specified, the materials exemplified in the above-described first and second embodiments can be used alone, or two or more thereof can be used in combination.

In addition, the present disclosure may have the following configurations.

(1) An actuator including:

a plurality of elastomer layers; and
a plurality of electrode layers,

wherein the elastomer layers and the electrode layers are alternately laminated, the electrode layer contains carbon black and a binder,
a content of the carbon black in the electrode layer is 10% by mass or more and 20% by mass or less, and
a specific surface area of the carbon black is 380 g/m$^2$ or more and 800 m$^2$/g or less.

(2) The actuator according to (1), wherein the carbon black has a porous structure.
(3) The actuator according to (1) or (2), wherein the electrode layer has an electrical resistivity of 30.0 Ω cm or less.
(4) The actuator according to any one of (1) to (3), wherein the electrode layer has an average thickness of 0.5 pm or more and 20 pm or less.
(5) The actuator according to any one of (1) to (4), wherein the electrode layer has a Young's modulus of 0.1 MPa or more and 5 MPa or less.
(6) The actuator according to any one of (1) to (5), wherein the electrode layer does not contain a dispersant.
(7) The actuator according to any one of (1) to (6), wherein the binder contains a silicone-based resin.
(8) The actuator according to any one of (1) to (7), wherein the elastomer layer contains a silicone-based resin.
(9) The actuator according to any one of (1) to (8), wherein the elastomer layer has an average thickness of 1 pm or more and 20 pm or less.
(10) The actuator according to any one of (1) to (9), wherein a Young's modulus of the elastomer layer is equal to or less than a Young's modulus of the electrode layer.
(11) The actuator according to any one of (1) to (10), wherein the elastomer layer has a Young's modulus of 0.05 MPa or more and 5 MPa or less.
(12) The actuator according to any one of (1) to (11), wherein a displacement rate in a lamination direction when a driving voltage of 300 V is applied is 0.5% or more.
(13) Electronic equipment comprising the actuator according to any one of (1) to (12).

[Reference Signs List]

10, 110 Actuator
10A, 110B Laminated body
11, 111 Elastomer layer
12A, 12B, 112A, 112B Electrode layer
13A, 13B External electrode
14A, 14B, 113A, 113B Lead-out electrode
15 Adhesive tape
110A Wound body
110SA, 110SB End face
112A1, 112A2 Extended portion
300 Imaging device (electronic equipment)
310 Camera body
311 Imaging element
312 Monitor
313 Electronic viewfinder
320 Imaging lens
321 Lens optical system
321A, 321B, 321C Lens
322A, 322B, 322C Holder
331 Lens support portion
332 Holder body

**Claims**

1. An actuator comprising:

    a plurality of elastomer layers; and
    a plurality of electrode layers,
    wherein the elastomer layers and the electrode layers are alternately laminated,

the electrode layer contains carbon black and a binder,
a content of the carbon black in the electrode layer is 10% by mass or more and 20% by mass or less, and
a specific surface area of the carbon black is 380 g/m$^2$ or more and 800 m$^2$/g or less.

2.  The actuator according to claim 1, wherein the carbon black has a porous structure.

3.  The actuator according to claim 1, wherein the electrode layer has an electrical resistivity of 30.0 Q cm or less.

4.  The actuator according to claim 1, wherein the electrode layer has an average thickness of 0.5 pm or more and 20 pm or less.

5.  The actuator according to claim 1, wherein the electrode layer has a Young's modulus of 0.1 MPa or more and 5 MPa or less.

6.  The actuator according to claim 1, wherein the electrode layer does not contain a dispersant.

7.  The actuator according to claim 1, wherein the binder contains a silicone-based resin.

8.  The actuator according to claim 1, wherein the elastomer layer contains a silicone-based resin.

9.  The actuator according to claim 1, wherein the elastomer layer has an average thickness of 1 pm or more and 20 pm or less.

10.  The actuator according to claim 1, wherein a Young's modulus of the elastomer layer is equal to or less than a Young's modulus of the electrode layer.

11.  The actuator according to claim 1, wherein the elastomer layer has a Young's modulus of 0.05 MPa or more and 5 MPa or less.

12.  The actuator according to claim 1, wherein a displacement rate in a lamination direction when a driving voltage of 300 V is applied is 0.5% or more.

13.  Electronic equipment comprising the actuator according to claim 1.

Fig. 1

Fig. 2

Fig. 3

A

113B  110SB  110  110DA

110DB

110A

113A

110SA

B

110

IIIC  113A  110SA

111
111

IIIC

110A

C

110

113B  110A  113A

110SB  110SA

111  112A    111  112B

Fig. 4

A

B

Fig. 5

Fig. 6

A

B

Fig. 7

Fig. 8

A

13B                                    10A                    13A

VIIIB    14B                                              14A    VIIIB

Y
Z⊙→X

10

B

13B    12B            11    10A    12A    13A

VIIIC                                              VIIIC

14B                                              14A

15

|←  5mm  →|←   10mm   →|←  5mm  →|

Z
Y⊗→X

10

C

13B                12B                13A

1mm

5mm

1mm

11

Y
Z⊙→X

24

## INTERNATIONAL SEARCH REPORT

| International application No. |
|---|
| **PCT/JP2022/004274** |

**A. CLASSIFICATION OF SUBJECT MATTER**

*H02N 2/04*(2006.01)i; *B32B 25/08*(2006.01)i; *B32B 27/18*(2006.01)i; *H01L 41/083*(2006.01)i; *H01L 41/09*(2006.01)i; *H01L 41/193*(2006.01)i
FI: H02N2/04; B32B27/18 J; H01L41/09; H01L41/083; H01L41/18 102; B32B25/08

According to International Patent Classification (IPC) or to both national classification and IPC

**B. FIELDS SEARCHED**

Minimum documentation searched (classification system followed by classification symbols)
H02N2/04; B32B25/08; B32B27/18; H01L41/083; H01L41/09; H01L41/193

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2019/065010 A1 (TOYODA GOSEI KK) 04 April 2019 (2019-04-04) entire text, all drawings | 1-13 |
| A | WO 2015/147167 A1 (SUMITOMO RIKO CO LTD) 01 October 2015 (2015-10-01) entire text, all drawings | 1-13 |
| A | JP 2010-124543 A (KURARAY CO LTD) 03 June 2010 (2010-06-03) entire text, all drawings | 1-13 |

☐ Further documents are listed in the continuation of Box C.   ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **20 April 2022** | **10 May 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

EP 4 293 892 A1

**INTERNATIONAL SEARCH REPORT**
Information on patent family members

International application No.

**PCT/JP2022/004274**

| Patent document cited in search report | | | Publication date (day/month/year) | Patent family member(s) | | | Publication date (day/month/year) |
|---|---|---|---|---|---|---|---|
| WO | 2019/065010 | A1 | 04 April 2019 | US | 2020/0350484 | A1 | |
| | | | | entire text, all drawings | | | |
| | | | | EP | 3672057 | A1 | |
| WO | 2015/147167 | A1 | 01 October 2015 | JP | 2015-189776 | A | |
| JP | 2010-124543 | A | 03 June 2010 | (Family: none) | | | |

Form PCT/ISA/210 (patent family annex) (January 2015)

**EP 4 293 892 A1**

REFERENCES CITED IN THE DESCRIPTION

**Patent documents cited in the description**

- JP 2010043880 A
- JP 2016069456 A